# EUROPEAN PATENT APPLICATION

(11) **EP 4 080 723 A1**
(43) Date of publication of application: **26.10.2022**
(21) Application number: 22169219.7
(22) Date of filing: 21.04.2022
(51) Int. Cl.: H02J 7/00

(54) **POWER CIRCUIT FOR BATTERY POWERED WEARABLE DEVICE**

(30) Priority: 23.04.2021 CN 202110463469
(71) Applicant: Harman International Industries, Incorporated, Stamford, CT 06901 (US)
(72) Inventor: FAN, Linyong, Shenzhen, 518067 (CN)
(74) Representative: Rummler, Felix

(57) **Abstract**

The present disclosure provides a power circuit for a battery powered wearable device. The circuit may include a first switch (102) and a second switch (104) successively coupled between the battery (110) of the wearable device and a power output terminal of the power circuit. The circuit may further include a control unit (108) configured to receive a detection signal indicating that a power switch (103) is switched off, and send, after completing required data processing before the wearable device is powered off based on the detection signal, a first control signal to the first switch, to control the first switch to be switched off and cause the second switch to be switched off, thereby cutting off power supply of the battery via the power output terminal.

## Description

### TECHNICAL FIELD

The present disclosure generally relates to the field of wearable devices, and in particular to, a power circuit for a battery powered wearable device.

### BACKGROUND

Generally, a power circuit of a battery powered wearable device may mainly include, e.g., a battery, a charger, a voltage regulator, a USB port, and a switch. The battery powers the wearable device, and the charger is used for charging the battery via an external power source. The external power source is usually connected to the wearable device via the USB port. The voltage regulator converts a battery voltage to some voltages for system components of the wearable device. When the wearable device is powered off, the power supply is cut off by a switch.

When an existing battery powered wearable device is switched off, usually there will be two designs. One design is that when the wearable device is powered off, the wearable device enters a sleep mode. The other design is that when the wearable device is powered off, the power supply is physically cut off. In the first design, the system components of the wearable device will still consume power in the sleep mode. In this case, the battery may be deeply discharged after certain time. In the second design, if the power supply is physically cut off, the system components of the device except for the battery itself will not consume any power. However, in this case, due to the immediate physical power-off, some UX (user interaction) functions before the device is powered off, such as power-off audio tone, cannot be implemented, nor may some data be stored. In addition, for the sake of safety, when a user is wearing and using the wearable device such as an earbud, it is often impossible to charge the wearable device.

Therefore, an improved technical solution is required, such that when the wearable device is powered off, the system components (except for the battery itself) consume no power, while providing the UX functions and guaranteeing that data is properly stored. In addition, an improved technical solution is further required, such that the wearable device can be safely used while being charged.

### SUMMARY

According to an aspect of the present disclosure, a power circuit for a battery powered wearable device is provided. The power circuit may include a first switch and a second switch. The first switch and the second switch are successively coupled between the battery of the wearable device and a power output terminal of the power circuit. The power circuit may further include a control unit. The control unit is configured to receive a detection signal indicating that a power switch is switched off, and send, after completing required data processing before the wearable device is powered off based on the detection signal, a first control signal to the first switch, to control the first switch to be switched off and cause the second switch to be switched off, thereby cutting off power supply of the battery via the power output terminal.

According to one or more embodiments, the power circuit may further include a delay circuit coupled between the power switch and the first switch. The delay circuit may send, in response to the power switch being switched off and after delay time, a delay control signal to the first switch to control the first switch to be switched off and cause the second switch to be switched off, thereby cutting off the power supply of the battery via the power output terminal.

According to one or more embodiments, the power circuit may further include a pulse circuit coupled between the power switch and the first switch. The pulse circuit may send, in response to the power switch being switched on, a pulse signal to the first switch to control the first switch to be closed and cause the second switch to be closed, such that the battery supplies power via the power output terminal.

According to one or more embodiments, the control unit may be activated in response to the power supply of the battery, and send, after being activated, a second control signal to the first switch, such that the first switch remains closed until the power switch is switched off.

According to one or more embodiments, the power circuit may further include a charger for charging the battery, and the control unit may set different values for a charging parameter of the charger based on whether the wearable device is in a power-on charging mode or a power-off charging mode.

According to one or more embodiments, the control unit receives a first battery temperature detection signal, and controls a charging process based on the first battery temperature detection signal; and/or the charger receives a second battery temperature detection signal, and controls the charging process based on the second battery temperature detection signal.

According to one or more embodiments, the power circuit may further include a diode. The diode is switched on to enable an external power source to not only supply power to the charger but also supply power to the power output terminal, where the charger charges the battery. An anode of the diode is coupled to an interface for connecting an external power source, and a cathode of the diode is coupled to the power output terminal.

According to one or more embodiments, the power circuit further includes a diode. The diode is switched on to enable the external power source to power the charger. The charger causes the second switch to be closed while charging the battery, and thus supplies power to the power output terminal. The anode of the diode is coupled to the charger, and the cathode of the diode is coupled to the power output terminal.

### BRIEF DESCRIPTION OF THE DRAWINGS

The present disclosure can be better understood by reading the following description of nonlimiting embodiments with reference to the accompanying drawings.
Fig. 1 schematically shows a functional block diagram of a power circuit according to one or more examples of an embodiment of the present disclosure;
Fig. 2 schematically shows a working process of switching circuit switching of a power circuit in power-on/power-off of a wearable device according to one or more embodiments of the present disclosure;
Fig. 3 shows a schematic diagram of charging management of the power circuit according to one or more embodiments of the present disclosure;
Fig. 4 schematically shows a functional block diagram of the power circuit according to one or more examples of another embodiment of the present disclosure;
Fig. 5 illustrates an example circuit corresponding to the functional block diagram of Fig. 1; and
Fig. 6 illustrates another example circuit corresponding to the functional block diagram of Fig. 1.

### DETAILED DESCRIPTION OF EMBODIMENTS

It should be understood that the following description of embodiments is given for illustrative purposes only, instead of limitations. The example division of functional blocks, modules, or units shown in the figures should not be construed as implying that these functional blocks, modules, or units must be implemented as physically separate units. The functional blocks, modules, or units that are shown or described may be implemented as separate units, circuits, chips, functional blocks, modules, or circuit elements. One or more functional blocks or units may also be implemented in a common circuit, chip, circuit element, or unit.

The use of singular terms (such as, but not limited to, "a") is not intended to limit the number of items. The use of relational terms, such as, but not limited to, "top," "bottom," "left," "right," "upper part," "lower part," "downward," "upward," "side," "first," "second," ("third", etc.) "entry," "exit," and the like, for written descriptions is for clearness in specific reference to the accompanying drawings, and is not intended to limit the scope of the present disclosure or the appended claims, unless otherwise specified. The terms "couple," "coupling," "coupled," "coupler," and similar terms are widely used herein, and may include any method or apparatus on or in or to or with which an intervening element, or one or more members are fixed, combined, bonded, fastened, attached, united, inserted, formed, or communicated, or otherwise any method or apparatus which is directly or indirectly mechanically, magnetically, electrically, chemically, or operatively associated with an intervening element, or one or more members, or may include, but is not limited to, any method or apparatus in which one member is integrated with another member. The coupling may occur in any direction, including rotational occurrence. The terms "including" and "such as" are illustrative, instead of limiting. Unless otherwise stated, the term "may" means "may, but not necessarily." Although any other language may be used in the present disclosure, the embodiments shown in the accompanying drawings are examples given for purposes of illustration and explanation, and are not the only embodiments of the subject matter herein.

In order to overcome the defects of the existing technical solutions, the present disclosure provides a power circuit for a battery powered wearable device. The power circuit includes a control switch and a control unit arranged between a battery and a power output terminal supplying power to an electrical component. The control unit may detect a power-off signal of a power switch, and when detecting the power-off signal of the power switch, first guarantees that a working system of the wearable device completes required relevant processing before power-off, such as storing data, and generating and playing a power-off audio, and then the control unit sends a control signal to the control switch to switch off the control switch, thereby completely cutting off the power supply of the battery to the electrical component via the power output terminal. The power circuit of the present disclosure not only can guarantee the timely storage of working data and the implementation of functions related to user interaction when the wearable device is switched off, but also can completely cut off power supply of the battery to the electrical component, thereby reducing power consumption of the battery. In addition, the power circuit provided in the present disclosure further can not only enable, when connecting with an external power source for charging, the control unit of the power circuit to monitor a battery temperature, but also enable a charger of the power circuit to monitor the battery temperature as well. Both the control unit and the charger can control the charging of the battery based on a monitoring result of the battery temperature, thereby improving the use safety of a user, guaranteeing that the wearable device can be safely charged while being used by the user, and further providing ease of use for the user.

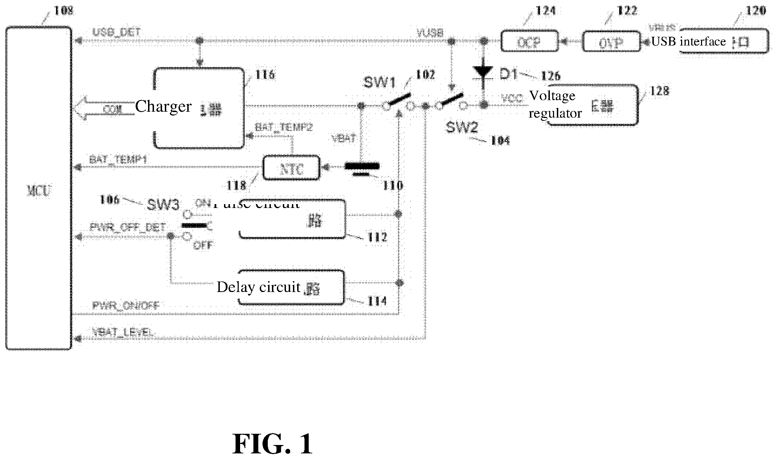

Power circuits in a plurality of examples of a plurality of embodiments of the present disclosure will be described in detail below with reference to the accompanying drawings. Fig. 1 shows a schematic functional block diagram of a power circuit according to one or more examples of an embodiment of the present disclosure. For ease of understanding, the present disclosure divides the power circuit into two portions based on main functions for description, for example, description of a circuit portion used for switching and a portion used for charging respectively. Those skilled in the art may understand that the example schematic functional block diagram of the power circuit is provided only for contributing to clear and comprehensive understanding of the content of the present disclosure, and is not intended to limit the present disclosure.

In some embodiments, for example, the circuit portion used for switch state switching in the power circuit may mainly include a first switch (SW1) 102, a second switch (SW2) 104, a third switch (SW3) 106, and a control unit 108 (e.g., a micro control unit MCU). The third switch SW3 is a power switch. The first switch SW1 102 and the second switch SW2 104 are electronic switches, e.g., may be triode switches or field effect transistor switches. The first switch SW1 102 and the second switch SW2 104 may be coupled between a battery 110 of the power circuit and a power output terminal supplying power to an electrical component of the wearable device. In some embodiments, for example, the power output terminal supplying power to an electrical component may be connected to a voltage regulator 128 to convert a supply voltage (e.g., VCC) to a voltage for a system component of the wearable device. In some embodiments, the control unit MCU 108 may detect a state of the power switch SW3 106, and upon receiving a detection signal (e.g., PWR_OFF_DET) indicating that the power switch is switched off, first executes required system processing before the device is powered off, and then sends a control signal (e.g., PWR_OFF) to the first switch SW1 102, where the control signal may control the first switch SW1 to be switched off, thereby cutting off the power supply of the battery 110 to the electrical component of the system via the power output terminal. In this case, the second switch SW2 may be switched off accordingly following the first switch SW2.

In some embodiments, the circuit portion for switching in the power circuit may include a pulse circuit 112. The pulse circuit 112 is coupled between the power switch SW3 106 and the first switch SW1 102, and sends, in response to the power switch 106 being switched on, a pulse signal to the first switch SW1 102 to control the first switch SW1 102 to be closed. In some embodiments, the circuit portion for switching in the power circuit further includes a delay circuit 114. The delay circuit 114 is coupled between the power switch SW3 106 and the first switch SW1 102 to send, in response to the power switch 106 being switched off for a period of delay time, a control signal to the first switch SW1 102 to control the first switch SW1 102 to be switched off.

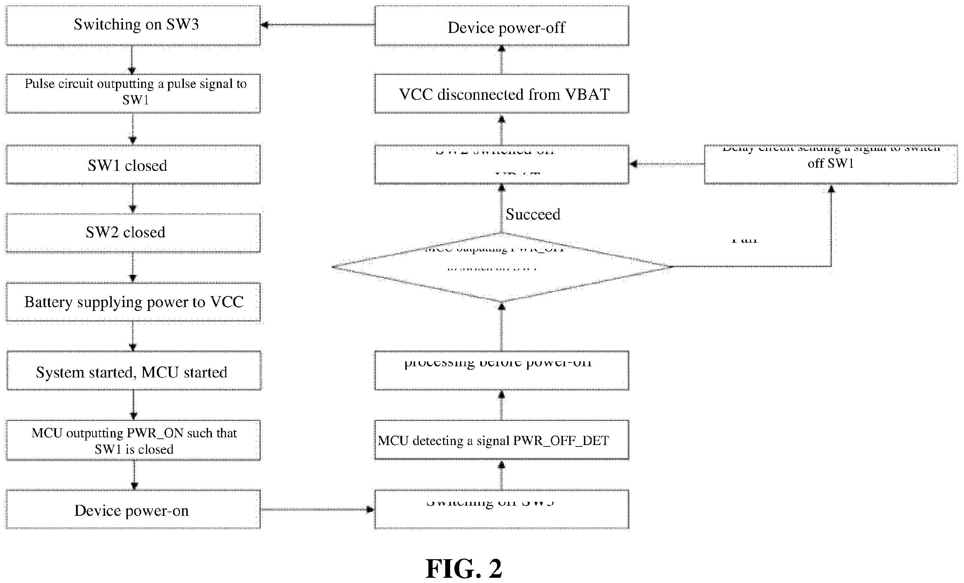

Fig. 2 shows a working process of the power circuit in power-on and power-off of a wearable device according to one or more embodiments of the present disclosure. Working processes of a circuit portion for switching in the power circuit in a power-on process and a power-off process of the wearable device will be further described below respectively with reference to Fig. 1 and Fig. 2.

For example, in the power-on process of the wearable device, when the power switch SW3 106 is switched on, the pulse circuit 112 will output a pulse signal to the first switch SW1 102. After receiving the pulse signal, the first switch SW1 102 will be closed. After the first switch SW1 102 is switched off, and when no external power source is connected through, for example, a USB interface 120, the second switch SW2 104 will be switched off accordingly following the first switch SW1 102. Then, the battery 110 will power an electrical component of the system. Due to the closure of the first switch SW1 102 and the second switch SW2 104, a battery voltage VBAT is provided to the power output terminal, and the power output terminal may supply power to a system component of the wearable device with a supply voltage VCC to start the system. After the system of the wearable device is started, the control unit MCU 108 will start to work and output a control signal (PWR_ON), such that the first switch SW1 remains closed until the wearable device is switched off again. In this case, the wearable device completes the power-on process. A duration of the pulse signal generated by the pulse circuit 112 may be equal to or longer than system startup time of the wearable device.

For example, in the power-off process of the wearable device, when the power switch SW3 106 is switched off (the power switch SW3 is switched from ON to OFF), the control unit MCU 108 will detect a signal indicating that the power switch is switched off, such as a PWR_OFF_DET signal. In this case, before the power-off, the control unit MCU 108 will execute some required processing, e.g., UX-related processing or processing such as storing data. For example, before the power-off, an earbud will play a power-off audio tone. After completing processing operations similar to the above, the MCU 108 will send a PWR_OFF signal to switch off the first switch SW1 102. Then, the second switch SW2 104 is also switched off, thereby cutting off power supply of the battery 110 to the electrical component of the system via the power output terminal, i.e., disconnecting a VCC terminal from a VBAT terminal. In this case, all components of the system, except for the battery itself, are completely powered off, thereby avoiding further consumption of battery power. The battery level may be notified to the control unit MCU 108 based on a VBAT_LEVEL signal. In some embodiments, the delay circuit 114 may be further arranged to send, after the power switch SW3 106 is switched off for a period of time (e.g., delay time), a control signal to the first switch SW1 104 to control the first switch SW1 104 to be switched off. The delay circuit may be arranged to guarantee that the first switch SW1 104 is switched off after a period of delay time when the control unit MCU 108 may not be able to switch off the first switch SW1 104. That is to say, the delay circuit may guarantee, in the case of software power-off failure, the complete power-off of the wearable device by hardware power-off, i.e., guarantee that all system components except for the battery no longer consume power. In some embodiments, the delay time may be set to be equal to or longer than the system power-off time.

Further referring to Fig. 1, the circuit portion for charging in the power circuit will be further described below. For example, the charging process may mainly involve a charger 116, the control unit MCU 108, a NTC 118 (e.g., a negative temperature coefficient sensing device), the first switch SW1 102, the second switch SW2 104, and a diode D1 126. An anode of the diode D1 126 is coupled to the interface (e.g., the USB interface) 120, and a cathode of the diode is coupled to the power output terminal VCC.

For example, as shown in the figures, the power circuit may be connected to an external power source through the USB interface 120 to charge the battery 110. VBUS is a voltage provided by the external power source via the USB interface 120. When the external power source is connected via the USB interface 120, the VUSB will output a high-level signal as a control signal to switch off the second switch SW2 104, thereby cutting off the power supply of the battery 110. At the same time, the diode D1 126 connected between the USB interface 120 and the power output terminal VCC is switched on. Thus, the external power source will power the electrical component of the system of the wearable device by switching on the diode D1 126.

In some examples, an overvoltage protection circuit OVP 122 and an overcurrent protection circuit OCP 124 may also be provided between the USB interface 120 and the charger 116, such that the external power source may power the charger 116 through the overvoltage protection circuit OVP 122 and the overcurrent protection circuit OCP 124. For example, the overvoltage protection circuit OVP 122 may be an IC for overvoltage protection. The overcurrent protection circuit OCP 124 may be an IC for overcurrent protection. In some examples, the overvoltage protection circuit OVP 122 and the overcurrent protection circuit OCP 124 may be provided between the anode of the diode D1 126 and the USB interface 120. Once the voltage VBUS provided by the external power source is higher than an overvoltage threshold, or a current provided by the external power source is higher than an overcurrent threshold, a connection between the power circuit and the external power source is cut off, i.e., a power supply connection between the external power source and the charger and a power supply connection between the external power source and the electrical component of the system are both cut off. For example, referring to Fig. 1, the VBUS will be disconnected from the VUSB, and the VBUS will be disconnected from the VCC.

For example, the control unit MCU 108 may detect whether an external power source is plugged into the USB interface 120 based on the USB detection signal (USB_DET). In addition, the control unit MCU 108 may communicate with the charger 116 based on I2C, SPI, GPIO or other protocols. The control unit MCU 108 may set a charging parameter and control the charging.

Both the control unit MCU 108 and the charger 116 monitor the battery temperature based on the NTC 118. For example, a NTC 116 may be driven by a current source or driven by a voltage source. If the NTC 116 is driven by a current source, one NTC is enough. If the NTC 116 is driven by a voltage source, it is necessary to set two NTCs. Both the control unit MCU 108 and the charger 116 may control the charging process based on the monitored battery temperature. For example, the NTC 118 may provide battery temperature detection signals, e.g., BAT_TEMP1 and BAT_TEMP2, to the control unit MCU 108 and the charger 116, respectively. Based on the battery temperature detection signals, both the control unit MCU108 and the charger 116 may control the charging process. The charging process may be enabled or disabled, and different charging parameters, such as charging current, may be set based on the battery temperature.

The power circuit designed in the present disclosure can enable the battery of the wearable device to be charged in both a power-on state and a power-off state. That is, there are two charging modes, one is a power-on charging mode, and the other is a power-off charging mode. Different values may be set for the charging parameter in the two modes. For example, the charging current in the power-on mode shall be lower than the charging current in the power-off mode, thereby reducing the temperature rise and improving the safety. To improve the safety, the power-on charging mode may have stricter temperature control. The charging process in the power-on mode and the charging process in the power-off mode will be further described in detail below respectively.

The charging process in the power-on mode is as follows. For example, in the power-on state, both the first switch SW1 102 and the second switch SW2 104 are closed. When connected to the external power source through the USB interface 120, the second switch SW2 104 is switched off under the control of a high-level control signal, thereby cutting off the power supply of the battery 110 to the electrical component of the system via the power output terminal. When the power circuit is connected to the external power source through the USB interface 120, the diode D1 126 is switched on, and then the external power source may power the electrical component of the system via the USB interface 120, the OVP 122 and the OCP 124 (one or both of the two may be selected based on actual needs), the diode D1 126, and the voltage stabilizer 128 (optionally provided as required). Further, the external power source may power the charger 116 through the USB interface 120, the OVP 122, and the OCP 124. The charger 116 charges the battery.

The charging process in the power-off mode is as follows. For example, in the power-off state, the first switch SW1 102 and the second switch SW2 104 are both disconnected, and the external power source can power the charger 116 only through the USB interface 120, the OVP 122 and the OCP 124 (one or both of the two may be selected based on actual needs). An output terminal of the charger 116 outputs electric energy, thus charging the battery 110. In this case, the battery 110 is disconnected from the electrical component of the system, thus failing to power the electrical component of the system.

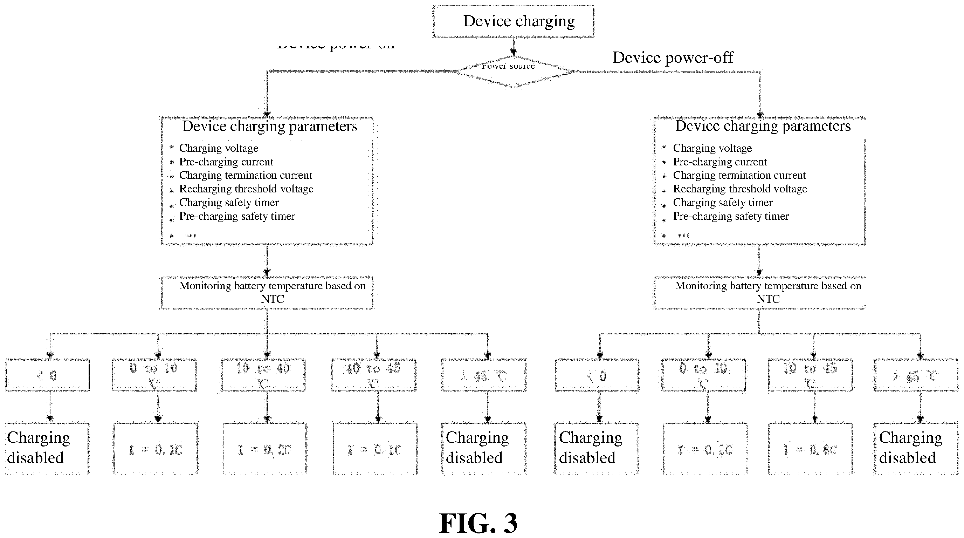

Fig. 3 shows a schematic diagram of charging management of the power circuit according to one or more embodiments of the present disclosure. Fig. 3 shows different management of charging processes when the wearable device is in a power-on state and in a power-off state, respectively. In a power-on charging mode and a power-off charging mode, charging parameters are set respectively, and different charging management is performed for the power-on charging mode and the power-off charging mode based on different management conditions.

For example, the charging parameters may include, but are not limited to, a charging voltage parameter, a pre-charging current parameter, a charging termination current parameter, a recharging threshold voltage parameter, a charging safety timer parameter, a pre-charging safety timer parameter, and the like.

As shown in Fig. 3, in the power-on charging mode, the battery temperature is monitored based on NTC. For example, when the temperature is lower than 0 °C, charging is disabled. When the temperature is higher than 0 °C and lower than 10 °C, the charging current may be set as 0.1C. When the temperature is higher than 10 °C and lower than 40 °C, the charging current may be set as 0.2C. When the temperature is higher than 40 °C and lower than 45 °C, the charging current may be set as 0.1C. When the temperature is higher than 45 °C, charging may be disabled.

In the power-off charging mode, the battery temperature is monitored based on the NTC. For example, when the temperature is lower than 0 °C, charging is disabled. When the temperature is higher than 0 °C and lower than 10 °C, the charging current may be set as 0.2C. When the temperature is higher than 10 °C and lower than 45 °C, the charging current may be set as 0.8C. When the temperature is higher than 45 °C, charging may be disabled.

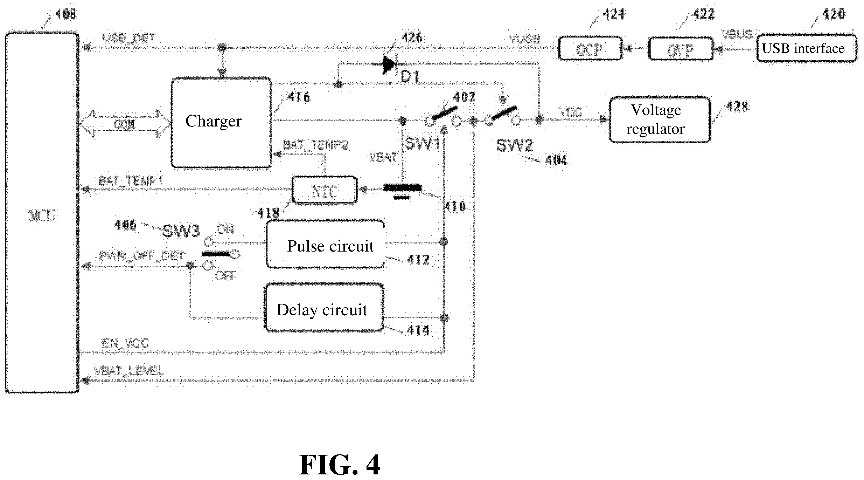

Fig. 4 schematically shows a functional block diagram of a power circuit according to one or more examples of an embodiment of the present disclosure. In Fig. 4, a working principle of the switching circuit portion is the same as that in Fig. 1. That is, the circuit working principle involving a first switch SW1 402, a second switch SW2 404, a power switch SW3 406, a control unit 408, a pulse circuit 412, and a delay circuit 414 is the same as that in Fig. 1. The solution on the switching circuit portion set forth with reference to Fig. 2 and Fig. 3 also applies to one or more examples of the embodiment of Fig. 4. Fig. 4 differs from Fig. 1 in a charging-associated circuit portion. In order to save space, the description of the same portion will not be repeated. The circuit portion associated with the charging process in Fig. 4 will be described below.

In the embodiment shown in Fig. 4, when an external power source is connected through a USB interface 420, the external power source powers a charger 416. In one or more examples of the embodiment of Fig. 4, output of the charger 416 is split into two portions, one portion is used for charging a battery 410, and the other portion is used for supplying power to an electrical component of the system. Compared with Fig. 1, this is implemented by changing a connection mode of a diode D1 426 and a control terminal of the second switch SW2 404. The detailed description will be provided below.

Specifically, for example, an anode of the diode D1 426 is connected to one output terminal of the charger 416, and a cathode of the diode is connected to a power output terminal (VCC). The other output terminal of the charger 416 is coupled to the battery. Further, a control signal of the second switch SW2 404 is a high-level voltage signal from the other terminal of the charger. When the external power source charges the wearable device through the USB interface 420, a voltage VBUS provided by the external power source contributes the charger to outputting a high-level voltage through an OVP 422 and an OCP 424, and the outputted high-level voltage switches off the second switch SW2 404 and switches on the diode D1. Therefore, in the power-on state, a part of the electrical energy outputted from the charger is used for charging the battery, and another part of the electrical energy outputted from the charger is used for supplying power to the electrical component, and in this case, the battery is disconnected from the electrical component.

The power circuit designed in Fig. 4 still can enable the battery of the wearable device to be charged in both the power-on state and the power-off state. That is, there are two charging modes, one is a power-on charging mode, and the other is a power-off charging mode. Different values may be set for the charging parameters in the two modes. For example, the charging current in the power-on mode shall be lower than the charging current in the power-off mode, thereby reducing the temperature rise and improving the safety. To improve the safety, the power-on charging mode may have stricter temperature control. Working principles of the charging process in the power-on mode and the charging process in the power-off mode will be further described in detail below.

The charging process in the power-on mode is as follows. For example, in the power-on state, both the first switch SW1 402 and the second switch SW2 402 are closed. When the external power source is connected through the USB interface 420, the external power source may power the charger 416. An output voltage of one output terminal of the charger 416 switches on the diode D1 426, and the high-level voltage signal outputted from the other output terminal switches off the second switch SW2 404. In this case, the power supply of the battery 410 to the electrical component is cut off. Instead, the voltage outputted from one output terminal of the charger supplies power to the electrical component of the system through the conducting diode D1. And, the other output terminal of the charger charges the battery 410.

The charging process in the power-off mode is as follows. In the power-off state, the first switch SW1 402 and the second switch SW2 404 are both switched off. When the external power source is connected through the USB interface 420, the external power source may power the charger 416. The other output terminal of the charger charges the battery 410. In this case, a high-level signal is still provided to the second switch SW2 404, such that the SW2 is still in an off state. The battery 410 is also disconnected from the electrical component in the power-off charging mode.

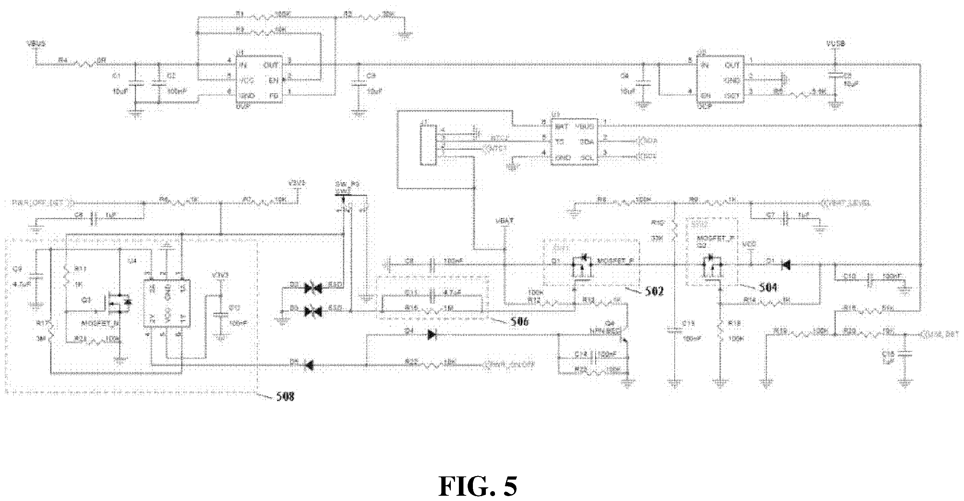

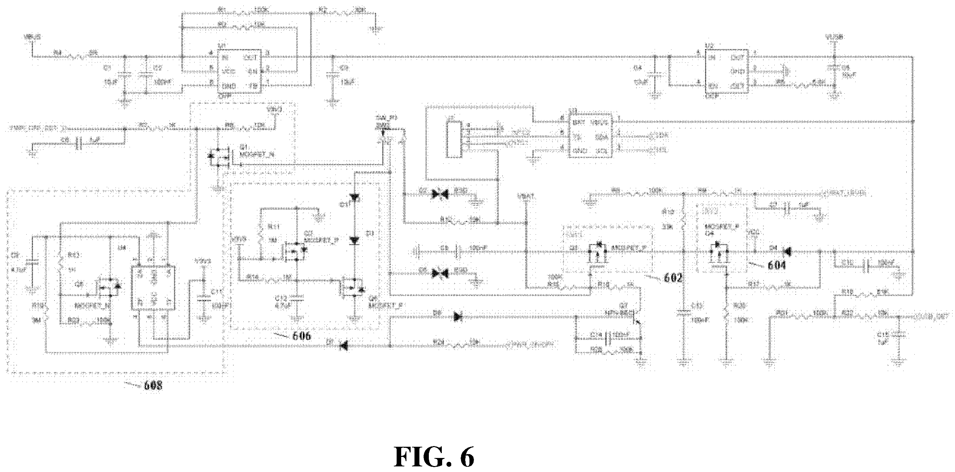

Fig. 5 and Fig. 6 show schematic diagrams of implementations of example circuits corresponding to the functional block diagram of Fig. 1, respectively. It is understandable that Fig. 5 and Fig. 6 are only schematic diagrams of implementations of example circuits given for those skilled in the art to better understand and implement the teachings of the present disclosure, rather than specific limitations to the technical solutions of the present disclosure.

For example, referring to the example of Fig. 5, the voltage VBUS shown in the upper part of the figure is from a VBUS pin of a USB interface. U1 is an overvoltage protection IC, i.e., an overvoltage protection circuit OVP. U2 is an overcurrent protection IC, i.e., an overcurrent protection circuit OCP. J1 in the figure is a battery connector, and U3 is a charger. In the implementation of Fig. 5, a battery has two NTCs. For example, NTC1 is connected to MCU, and NCT2 is connected to the charger. The charger may communicate with the MCU via I2C. V3V3 is generated by a voltage regulator. The voltage regulator is powered by VCC. SW3 is a power switch. For example, in the SW3, Pin1 is an OFF electrode, Pin2 is an ON electrode, and Pin3 is a common electrode.

In the lower part of Fig. 5, several dashed blocks are shown. For example, enclosed by a dashed block 502, a first switch SW1 is implemented by a field effect transistor (MOSFET_P) Q1. Enclosed by a dashed block 504, a second switch SW2 is implemented by a field effect transistor (MOSFET_P) Q2.

Enclosed by a dashed block 506, a pulse circuit includes a resistor R15 and a capacitor C11. A duration of a pulse signal generated by the pulse circuit depends on values of the resistor R15 and the capacitor C11. For example, the duration may approximately be a value of a product of the R15 and the C11, i.e., R15^{∗}C11.

Enclosed by a dashed block 508, a delay circuit mainly includes a gate inverter U4, a field effect transistor Q3, a resistor R17, and a capacitor C9. Delay time of the delay circuit depends on values of the R17 and the capacitor C9. For example, the delay time may approximately be a value of a product of the R17 and the C9, i.e., R17^{∗}C9.

Fig. 6 shows another implementation example. For example, referring to the example of Fig. 6, the voltage VBUS shown in the upper part of the figure is from a VBUS pin of a USB interface. U1 is an overvoltage protection IC, i.e., an overvoltage protection circuit OVP. U2 is an overcurrent protection IC, i.e., an overcurrent protection circuit OCP. J1 in the figure is a battery connector, and U3 is a charger. In the implementation of Fig. 6, a battery has two NTCs. For example, NTC1 is connected to MCU, and NCT2 is connected to the charger. The charger may communicate with the MCU via I2C. V3V3 is generated by a voltage regulator. The voltage regulator is powered by VCC. SW3 is a power switch. For example, in the SW3, Pin1 is an OFF electrode, Pin2 is an ON electrode, and Pin3 is a common electrode.

In the lower part of Fig. 6, several dashed blocks are shown. For example, enclosed by a dashed block 602, a first switch SW1 is implemented by a field effect transistor (MOSFET_P) Q3.

Enclosed by a dashed block 604, a second switch SW2 is implemented by a field effect transistor (MOSFET_P) Q4.

Enclosed by a dashed block 606, a pulse circuit includes a field effect transistor Q2, a field effect transistor Q6, a resistor R11, a resistor R14, a capacitor C12, a diode D1, and a diode D3. A duration of a pulse signal generated by the pulse circuit depends on values of the resistor R14 and the capacitor C12. For example, the duration may approximately be a value of a product of the R14 and the C12, i.e., R14^{∗}C12.

Enclosed by a dashed block 608, a delay circuit mainly includes a gate inverter U4, a field effect transistor Q1, a field effect transistor Q5, a resistor R19, and a capacitor C9. Delay time of the delay circuit depends on values of the R19 and the capacitor C9. For example, the delay time may approximately be a value of a product of the R19 and the C9, i.e., R19^{∗}C9.

### Further Examples

Example 1. A power circuit for a battery powered wearable device, comprising:
   a first switch and a second switch successively coupled between the battery of the wearable device and a power output terminal of the power circuit; and
   a control unit configured to receive a detection signal indicating that a power switch is switched off, and send, after completing required data processing before the wearable device is powered off based on the detection signal, a first control signal to the first switch, to control the first switch to be switched off and cause the second switch to be switched off, thereby cutting off power supply of the battery via the power output terminal.
Example 2. The power circuit according to example 1, further comprising a delay circuit coupled between the power switch and the first switch, wherein the delay circuit sends, in response to the power switch being switched off and after delay time, a delay control signal to the first switch to control the first switch to be switched off and cause the second switch to be switched off, thereby cutting off the power supply of the battery via the power output terminal.
Example 3. The power circuit according to example 1 or 2, further comprising a pulse circuit coupled between the power switch and the first switch, wherein the pulse circuit sends, in response to the power switch being switched on, a pulse signal to the first switch to control the first switch to be closed and cause the second switch to be closed, such that the battery supplies power via the power output terminal.
Example 4. The power circuit according to example 3, wherein the control unit is activated in response to the power supply of the battery, and sends, after being activated, a second control signal to the first switch, such that the first switch remains closed until the power switch is switched off.
Example 5. The power circuit according to example 1 or 2, further comprising a charger for charging the battery, and the control unit setting different values for a charging parameter of the charger based on whether the wearable device is in a power-on charging mode or a power-off charging mode.
Example 6. The power circuit according to example 5, wherein
   the control unit receives a first battery temperature detection signal, and controls a charging process based on the first battery temperature detection signal; and/or
   the charger receives a second battery temperature detection signal, and controls the charging process based on the second battery temperature detection signal.
Example 7. The power circuit according to example 6, further comprising a diode, wherein the diode is switched on to enable an external power source to not only supply power to the charger but also supply power to the power output terminal, wherein the charger charges the battery.
Example 8. The power circuit according to example 7, wherein an anode of the diode is coupled to an interface for connecting an external power source, and a cathode of the diode is coupled to the power output terminal.
Example 9. The power circuit according to example 6, further comprising a diode, wherein the diode is switched on to enable an external power source to power the charger, and the charger causes the second switch to be closed while charging the battery, and thus supplies power to the power output terminal.
Example 10. The power circuit according to example 9, wherein the anode of the diode is coupled to the charger, and the cathode of the diode is coupled to the power output terminal.

The description of embodiments has been presented for the purposes of illustration and description. Appropriate modifications and alterations to the embodiments may be executed in light of the above description, or may be acquired by practice. The described methods and associated actions may also be executed in various sequences other than the sequence described herein, in parallel, and/or concurrently. The described system is essentially an example, and may include additional elements and/or omit elements. The subject matter of the present disclosure includes all novel and non-obvious combinations of the various disclosed systems and configurations and additional features, functions, and/or properties.

As used herein, an element or step recited in a singular form and preceded by a word "a/an" should be understood as not excluding a plurality of said elements or steps, unless such exclusion is indicated. Further, the reference to "an embodiment" or "an example" of the present disclosure is not intended to be interpreted as excluding the existence of additional embodiments that also incorporate the recited features. The present disclosure has been described above with reference to particular embodiments. However, as will be appreciated by those of ordinary skills in the art, various modifications and alterations may be made to the present disclosure without departing from the broad spirit and scope of the present disclosure as set forth in the appended claims.

## Claims

1. A power circuit for a battery powered wearable device, comprising:
a first switch and a second switch successively coupled between the battery of the wearable device and a power output terminal of the power circuit; and
a control unit configured to receive a detection signal indicating that a power switch is switched off, and send, after completing required data processing before the wearable device is powered off based on the detection signal, a first control signal to the first switch, to control the first switch to be switched off and cause the second switch to be switched off, thereby cutting off power supply of the battery via the power output terminal.

2. The power circuit according to claim 1, further comprising a delay circuit coupled between the power switch and the first switch, wherein the delay circuit sends, in response to the power switch being switched off and after delay time, a delay control signal to the first switch to control the first switch to be switched off and cause the second switch to be switched off, thereby cutting off the power supply of the battery via the power output terminal.

3. The power circuit according to claim 1 or 2, further comprising a pulse circuit coupled between the power switch and the first switch, wherein the pulse circuit sends, in response to the power switch being switched on, a pulse signal to the first switch to control the first switch to be closed and cause the second switch to be closed, such that the battery supplies power via the power output terminal.

4. The power circuit according to claim 3, wherein the control unit is activated in response to the power supply of the battery, and sends, after being activated, a second control signal to the first switch, such that the first switch remains closed until the power switch is switched off.

5. The power circuit according to claim 1 or 2, further comprising a charger for charging the battery, and the control unit setting different values for a charging parameter of the charger based on whether the wearable device is in a power-on charging mode or a power-off charging mode.

6. The power circuit according to claim 5, wherein
the control unit receives a first battery temperature detection signal, and controls a charging process based on the first battery temperature detection signal; and/or
the charger receives a second battery temperature detection signal, and controls the charging process based on the second battery temperature detection signal.

7. The power circuit according to claim 6, further comprising a diode, wherein the diode is switched on to enable an external power source to not only supply power to the charger but also supply power to the power output terminal, wherein the charger charges the battery.

8. The power circuit according to claim 7, wherein an anode of the diode is coupled to an interface for connecting an external power source, and a cathode of the diode is coupled to the power output terminal.

9. The power circuit according to claim 6, further comprising a diode, wherein the diode is switched on to enable an external power source to power the charger, and the charger causes the second switch to be closed while charging the battery, and thus supplies power to the power output terminal.

10. The power circuit according to claim 9, wherein the anode of the diode is coupled to the charger, and the cathode of the diode is coupled to the power output terminal.
